# EUROPÄISCHE PATENTSCHRIFT

(11) **EP 0 474 081 B1**
(45) Veröffentlichungstag und Bekanntmachung des Hinweises auf die Patenterteilung: **26.10.1994**
(21) Anmeldenummer: 91114253.7
(22) Anmeldetag: 26.08.1991
(51) Int. Cl.: H05K 7/14, H01R 13/645

(54) **Codiervorrichtung für auf eine Rückwandverdrahtung aufsteckbare elektrische Baugruppen**
Coding device for mounting electric elements onto a rear panel wiring
Dispositif de codage pour assemblage électrique branchable sur un câblage de panneau-arrière

(30) Priorität: 04.09.1990 DE 9012635 U
(43) Veröffentlichungstag der Anmeldung: 11.03.1992
(73) Patentinhaber: SIEMENS AKTIENGESELLSCHAFT, 80333 München (DE)
(72) Erfinder: Zell, Karl, Dipl.-Ing., W-8134 Niederpöcking (DE); Heimüller, Hans-Jost, W-6724 Dudenhofen (DE); Seidel, Peter, W-8038 Gröbenzell (DE)

(56) Entgegenhaltungen:
- EP-A- 0 392 629
- EP-A- 0 394 753
- DE-A- 2 021 547
- DE-A- 3 318 137
- DE-A- 3 432 048
- DE-A- 3 630 950
- DE-U- 1 895 660
- US-A- 4 772 227

## Beschreibung

Die Erfindung betrifft eine Codiervorrichtung für auf eine Rückwandverdrahtung aufsteckbare elektrische Baugruppen, wobei die Rückwandverdrahtung aus einer Rückwandleiterplatte mit eingesetzten Kontaktmessern und darauf aufsteckbaren als einseitig offene rechtwinkelige Gehäuse ausgebildeten Messerleisten zur Aufnahme von Federleisten, die mit elektrischen Baugruppen fest verbunden sind, besteht, und wobei sowohl die Messerleisten als auch die Federleisten aus einzelnen Teilleisten bestehen, deren Längen dem ein- oder mehrfachen der Länge eines vorgegebenen Teilsegments entsprechen.

Derartige Rückwandverdrahtungen sind z. B. aus dem deutschen Gebrauchsmuster 85 09 375 bekannt. Ihr Vorteil besteht darin, daß bei einer mit rasterförmig angeordneten Stiften belegten Rückwandleiterplatte eine einzige Ausführungsform für alle sich möglicherweise ergebenden Anforderungen genügt.

Für derartige Rückwandverdrahtungen sind die herkömmlichen Codiervorrichtungen nicht geeignet, da ein Teil der Codiervorrichtung neben der Messerleiste angeordnet sein muß, und damit eine optimale Bestückung der Rückwandleiterplatte mit Baugruppen nicht mehr realisierbar ist. Eine derartige herkömmliche Codiervorrichtung für eine aus Messer- und Federleiste bestehende Steckverbindung ist z. B. aus dem deutschen Gebrauchsmuster 84 28 427 bekannt.

Aufgabe der vorliegenden Erfindung ist es, eine Codiervorrichtung der eingangs genannten Art anzugeben, die bei einer Rückwandleiterplatte mit eingesetzten Kontaktmessern eine optimale Bestückung der Rückwandleiterplatte mit Baugruppen ermöglicht.

Diese Aufgabe wird erfindungsgemäß für eine Codiervorrichtung der oben genannten Art dadurch gelöst, daß Teilleisten sowohl der Messerleiste als auch der Federleiste von der Länge eines Teilsegments als korrespondierende Codiereinheiten ausgebildet sind und an beliebiger Stelle der Leisten anbringbar sind, wobei jeweils anstelle einer vorgegebenen Anzahl von Kontaktmessern und den dazu korrenspondierenden Aufnahmefedern Codiereinheiten vorgesehen sind.

Da bei der erfindungsgemäßen Codiervorrichtung die Codiereinheiten innerhalb der Abmessung der Codierleisten angeordnet sind, kann bei der erfindungsgemäßen Codiervorrichtung die Rückwandleiterplatte optimal mit Baugruppen bestückt werden.

Eine zweckmäßige Ausgestaltung der erfindungsgemäßen Codiervorrichtung ist, dadurch gekennzeichnet, daß die Codiereinheiten einerseits aus Vertiefungen und andererseits aus Stiften bestehen. Diese Ausführungsform ermöglicht auf einfache Weise eine große Anzahl von Codiermöglichkeiten.

Im folgenden wird die Erfindung anhand in der Zeichnung dargestellten Ausführungsbeispiels näher erläutert.

Es zeigen
- FIG 1: die perspektivische Ansicht einer Messerleiste zur Aufnahme der Kontaktmesser der Rückwandleiterplatte,
- FIG 2: die perspektivische Ansicht einer entsprechenden Federleiste zum Aufstecken auf die Kontaktmesser,

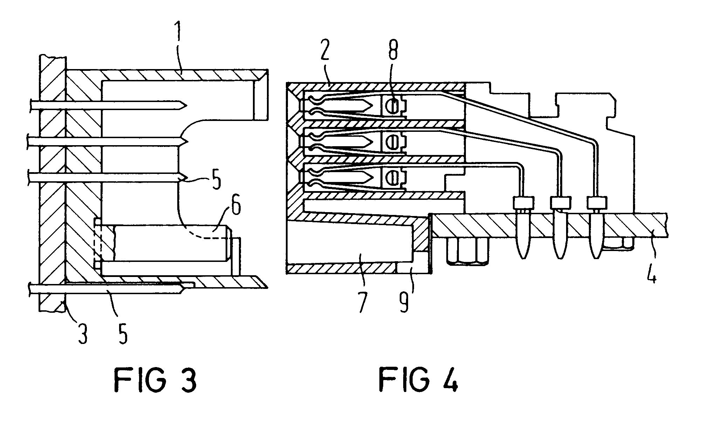

- FIG 3: ein Querschnitt durch eine Messerleiste mit einer Codiereinheit gemäß der vorliegenden Erfindung und
- FIG 4: einen Querschnitt durch eine Federleiste mit einer entsprechenden Codiereinheit gemäß der vorliegenden Erfindung.

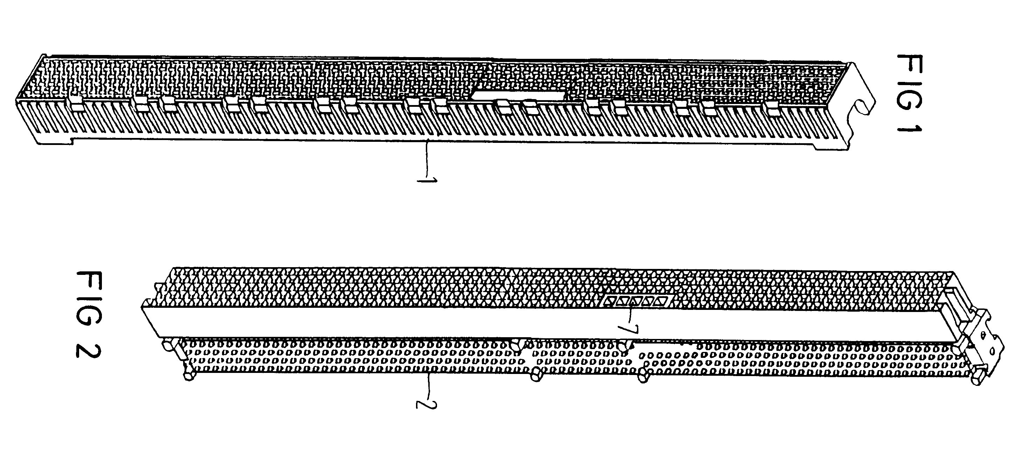

Figur 1 zeigt eine Messerleiste 1, die im wesentlichen aus einem einseitig offenen rechtwinkeligen Gehäuse besteht, in dessen Boden Öffnungen für die Kontaktmesser der Rückwandleiterplatte 3 angeordnet sind. Figur 2 zeigt die dazugehörige Federleiste 2 die fest mit einer Baugruppenleiterplatte 4 verbunden ist. Sowohl die Messerleisten 1 als auch die Federleisten 2 bestehen aus einzelnen Teilleisten, deren Längen dem ein- oder mehrfachen der Länge eines vorgegebenen Teilsegments entsprechen wie es in den Figuren 1 und 2 angedeutet ist.

Pro Teilsegment können z. B. fünf Codierstifte 6 auf eines der Seiten der Messerleiste 1 und entsprechend fünf Codierkammern 7 auf der entsprechenden Federleiste 2 vorgesehen sein. Die Codierstifte 6 können abgebrochen werden und in die Codierkammern 7 eingedrückt werden. Ebenso ist das Eindrücken separater Codierstifte in die Codierkammern möglich. Eine Freisparung 9 im entsprechenden Teilsegment der Federleiste 2 ermöglicht ein Entfernen der eingedrückten Codierstifte.

## Patentansprüche

1. Codiervorrichtung für auf eine Rückwandverdrahtung aufsteckbare elektrische Baugruppen, wobei die Rückwandverdrahtung aus einer Rückwandleiterplatte mit eingesetzten Kontaktmessern und darauf aufsteckbaren als einseitig offene rechtwinkelige Gehäuse ausgebildete Messerleisten zur Aufnahme von Federleisten, die mit elektrischen Baugruppen fest verbunden sind, besteht, und wobei sowohl die Messerleisten als auch die Federleisten aus einzelnen Teilleisten bestehen, deren Längen dem ein- oder mehrfachen der Länge eines vorgegebenen Teilsegments entsprechen,
**dadurch gekennzeichnet**,
daß Teilleisten sowohl der Messerleiste (1) als auch der Federleiste (2) von der Länge eine Teilsegments als korrespondierende Codiereinheiten (6, 7) ausgebildet sind und an beliebigen Stellen der Leisten (1, 2) anbringbar sind, wobei jeweils anstelle einer vorgegebenen Anzahl von Kontaktmessern (5) und den dazu korrespondierenden Aufnahmefedern (8) Codiereinheiten (6, 7) vorgesehen sind.

2. Codiervorrichtungen nach Anspruch 1,
**dadurch gekennzeichnet,**
daß die Codiereinheiten (6, 7) einerseits aus Vertiefungen (7) und andererseits aus Stiften (6) bestehen.

## Claims

1. Coding device for electric components which can be mounted on a rear panel wiring, the rear panel wiring comprising a rear panel circuit board with fitted contact blades and male multipoint connectors which can be mounted on the latter, are designed as right-angled enclosures which are open on one side and are for receiving female multipoint connectors, which are firmly connected to electrical components, and both the male multipoint connectors and female multipoint connectors comprising individual subconnectors, the lengths of which correspond to one or more times the length of a predetermined subsegment, characterized in that subconnectors both of the male multipoint connector (1) and of the female multipoint connector (2) of the length of a subsegment are designed as corresponding coding units (6,7) and can be fitted on at any desired points of the multipoint connectors (1,2), coding units (6,7) being provided in each case instead of a predetermined number of contact blades (5) and the resilient sockets (8) corresponding to them.

2. Coding devices according to Claim 1, characterized in that the coding units (6,7) comprise on the one hand depressions (7) and on the other hand pins (6).

## Revendications

1. Dispositif de codage pour des modules électriques, qui peuvent être enfichés sur un câblage de paroi arrière, et dans lequel le câblage de paroi arrière est constitué par une plaquette à circuits imprimés de paroi arrière, dans laquelle sont insérés des couteaux de contact, et comportant des connecteurs à couteaux pouvant être enfichés sur ces couteaux et réalisés sous la forme de boîtiers rectangulaires ouverts d'un côté et destinés à recevoir des connecteurs à ressorts, qui sont reliés de façon fixe à des modules électriques, et dans lequel aussi bien les connecteurs à couteaux que les connecteurs à ressorts sont constitués par des parties individuelles de connecteurs dont les longueurs correspondent à la longueur d'un segment partiel prédéterminé ou un multiple de cette longueur, caractérisé par le fait que des parties aussi bien du connecteur (1) à couteaux que du connecteur (2) à ressorts possédant la longueur d'un segment partiel sont réalisés sous la forme d'unités (6, 7) de codage correspondantes et peuvent être montées en des emplacements quelconques des connecteurs (1, 2), des unités (6, 7) de codage étant prévues respectivement à la place d'un nombre prédéterminé de couteaux (5) de contact et des ressorts (8) de réception, qui leur correspondent.

2. Dispositif de codage suivant la revendication 1, caractérisé par le fait que les unités (6,7) de codage sont constituées, d'une part, par des renfoncements (7) et, d'autre part, par des broches (6).
